# EUROPEAN PATENT APPLICATION

(11) **EP 4 845 344 A1**
(43) Date of publication of application: **25.11.2026**
(21) Application number: 25178593.7
(22) Date of filing: 23.05.2025
(51) Int. Cl.: H10F 10/19, H10F 77/20

(54) **TANDEM SOLAR CELL AND METHOD OF MANUFACTURING THE SAME**

(71) Applicant: Nederlandse Organisatie voor toegepast- natuurwetenschappelijk onderzoek TNO, 2595 DA 's-Gravenhage (NL)
(72) Inventor: GEERLIGS , Lambert Johan, 2595 DA `s- Gravenhage (NL); TEN KATE, Otmar Melvin, 2595 DA `s- Gravenhage (NL); GUILLEVIN, Nicolas, 2595 DA `s- Gravenhage (NL)
(74) Representative: V.O.

(57) **Abstract**

A tandem solar cell (1) is provided herein that comprises a stack of at least a first photovoltaic component (10) that defines a first main side (1F) and a second photovoltaic component (20) that defines a second main side (1R). The tandem solar cell (1) is configured to perform a photovoltaic conversion of light and to provide electrical energy resulting from the photovoltaic conversion to electric contacts (31, 32, 33) at the second main side (1R). The electric contacts comprise at least a first electric contact (31) that is electrically connected by a via connection (310) through the stack to a charge carrier selective contact layer (211) of the first photovoltaic component (10) at the first main side (1F), and a second electric contact (32) and a third electric contact (33) that are connected to respective charge carrier selective contact layers (232, 233) of the second photovoltaic component (20) at the second main side (1R).

## Description

### BACKGROUND

The present application pertains to a tandem solar cell.

The present application further pertains to a method of manufacturing a tandem solar cell.

A tandem solar cell comprises two photovoltaic components, also denoted briefly as subcells, stacked on top of each other. The two photovoltaic components have mutually different light-absorbing layers (for example perovskite for the top subcell with crystalline silicon (c-Si) for the bottom subcell), allowing for higher efficiencies compared to single junction devices, as different spectral ranges of sunlight are absorbed more efficiently with less thermalization losses.

Each of the photovoltaic components can comprise more than one light-absorbing layer. For example, the top subcell can itself be a tandem cell with two mutually different light-absorbing perovskite absorber layers.

In 2-terminal (2T) tandem solar cells, the two photovoltaic components are connected in series via a recombination junction, where p-type charge carriers from one subcell recombine with n-type charge carriers from the other subcell. While this 2T tandem solar cell is a relatively simple device architecture having only contact terminals at the front and rear side of the device, it has the disadvantage that the two photovoltaic components need to be current-matched for maximum efficiency, which in practical operation often limits the overall efficiency due to light spectrum variations, bifacial operation, variation of generation efficiency in the subcells, and the like.

4-terminal (4T) devices on the other hand do not have this disadvantage, but require means for facilitating a lateral charge transport, such as a grid on the top of the bottom subcell, or in case of the perovskite top subcell: a so-called monolithic interconnection. Also these devices require an intermediate isolating layer for the middle contacts between the two photovoltaic components. These requirements entail challenges, such as, with regard to interconnections and power electronics in particular when scaling to large device areas. Further disadvantages are current losses due to parasitic absorption, and an increased sensitivity to partial shading.

3-terminal (3T) tandem devices are an alternative tandem configuration with the advantage that the two photovoltaic components do not have to be current-matched, while there is no need for the lateral charge transport for current extraction to the middle contacts. This configuration thus combines the advantages of both 2T and 4T, resulting in potentially higher efficiencies and higher energy yield. This can be achieved in a 3T IBC configuration, in which the bottom photovoltaic component is an interdigitated back contact (IBC) subcell. In IBC (sub)cells, both charge extraction layers, and their external contacts are positioned at the rear side in an interdigitated layout, therewith avoiding a middle contact for the bottom photovoltaic component. Typically these contacts are called the emitter and the base contact; the emitter extracts the minority carriers from the wafer, such as holes from an n-type wafer, and the base contact extracts the majority carriers from the wafer, such as electrons from an n-type wafer.

Single junction back-contact (BC) silicon (sub)cells, like IBC (sub)cells, have multiple advantages over non-BC (sub)cells. As all contacting is done via the rear side, there is less or no metallization needed at the front side, resulting in higher efficiencies, because of reduced shading and better front surface passivation. Moreover, it can make BC (sub)cells aesthetically more pleasing; and there will be less mechanical stress on the (sub)cells if all contacting is done solely via the rear side.

However, in 3T IBC tandem cells (like also in general for 2T and 4T tandem devices) there is still a need for a front contact to collect charges from the perovskite top subcell. This basically removes many of the advantages (reduced shading, stress, aesthetics) that a BC cell by itself would have. A full back-contact tandem device could potentially obtain higher efficiencies.

Metallization Wrap Through (MWT) solar cells are another back-contact cell technology in which the front metallization extends to the rear side using through-hole metal connections. The application of MWT technology for single junction silicon devices is relatively well known, and has been considered for 2T silicon-perovskite tandem configurations as well. Yet another back-contact solar cell technology is Emitter Wrap Through (EWT), which makes use of holes in the wafer, through which the emitter at the front of the wafer is connected to contacts at the back of the wafer. In contrast to MWT, the EWT cell does not have front metallization.

CN114256387B discloses a back contact 3T tandem configuration having a first type of MWT that extends through the whole tandem stack, and a second type of MWT that extends from a middle contact through the bottom subcell. This has the disadvantage that the manufacturing of such a device would be rather complex, as the two different types of through-holes need to be made in two separate processing steps, and the deposition of the layers of the top subcell on top of the first series of vias would not be straightforward. Furthermore, the presence of many vias decreases the active surface area of the solar cell, increases recombination losses, and decreases mechanical stability.

### SUMMARY

It is an object to at least mitigate one or more of these disadvantages. In accordance therewith, an improved tandem solar cell is provided that comprises a stack of at least a first photovoltaic component and a second photovoltaic component. The first photovoltaic component defines a first main side, and the second photovoltaic component defines a second main side. The tandem solar cell is configured to perform a photovoltaic conversion of light and to provide electrical energy resulting from electric contacts at the second main side. The electric contacts comprise at least a first electric contact that is electrically connected by a via connection through the stack to a charge carrier selective contact layer of the first photovoltaic component at the first main side and a second electric contact and a third electric contact that are connected to respective charge carrier selective contact layers of the second photovoltaic component at the second main side. As all electric contacts are provided at the second main side, parasitic absorption of optical radiation received at its first main side is mitigated. Therewith the improved solar cell is optimally configured to perform a photovoltaic conversion of light received from the first main side. Nevertheless, the tandem solar cell may to a certain extent also be configured to perform a photovoltaic conversion of light received from the second main side.

It is noted that the at least a first electric contact may in practice be one of a plurality of first electric contacts that each are electrically connected by a respective via connection through the stack to the charge carrier selective contact layer of the first photovoltaic component at the first main side. Likewise, the second electric contact may be one of a plurality of second electric contacts that each are connected to a respective charge carrier selective contact layer at the second main side. Similarly, the third electric contact may be one of a plurality of third electric contacts that each are connected to a respective charge carrier selective contact layer at the second main side.

In an embodiment the second photovoltaic component comprises a silicon based photovoltaic conversion layer. The long charge carrier diffusion length of a silicon based photovoltaic conversion layer is favorable in combination with the configuration of the second and third electric contacts at the second main side.

In an embodiment the first photovoltaic component comprises one or more perovskite based photovoltaic conversion layers. This is advantageous in that the wavelength range wherein it absorbs and converts optical radiation into electrical energy can be tuned to complement the absorption range of the second photovoltaic component.

In an embodiment the improved tandem solar cell is provided with a first electric contact grid at the first main side that electrically connects the via connection with the charge carrier selective contact layer of the first photovoltaic component. Various examples of a contact grid are specified in the detailed description. Alternatively, the via connection is directly electrically connected to a charge carrier selective contact layer of the first photovoltaic component, or a layer stack including such a charge carrier selective contact layer. A layer stack may include a transparent conductive oxide layer, which is usually not carrier selective, but enhances lateral conductivity. As noted above the at least a first electric contact may in practice be one of a plurality of first electric contacts that each are electrically connected by a respective via connection through the stack to the charge carrier selective contact layer of the first photovoltaic component at the first main side. In the alternative embodiment the absence of a first electric contact grid may be compensated by the presence of a relatively large number of via connections. Due to their relatively large number these via connections may have a relatively small cross-diameter.

In an embodiment the via connection is surrounded by a hull of an electrically insulating material and the first electric contact is provided at an end surface of the hull at the second main side. This mitigates the risk of parasitical current paths and of a chemical degradation of stack materials. The latter may for example occur in case of a direct contact between a metallic component of the via and a perovskite material in a photovoltaic component.

In an embodiment the hull may comprise a layer of material that has an electrically passivating effect for the surface of one or more layers in the stack of the photovoltaic component. This material could, for example, be a layer deposited by atomic layer deposition (ALD), such as for example aluminum oxide.

In a typical case wherein the first electric contact is one of a plurality of first electric contacts, each via is typically applied with such a hull. In an example the hull or each hull has a widened end portion at the second main side. The widened end portion may be provided as a disk, having a diameter exceeding that of an outer diameter of the hull inside the stack. The widened end portion facilitates electrically connecting the via connection, in that it allows a larger area for a metallic contact pad connected to the via connection. In that way, a risk of misalignment is reduced, and a tolerance in the size of a solder connection to the via connection is increased.

In an embodiment the widened end portion, for example a disk shaped end portion extends over one or more charge carrier selective contact layers. In another embodiment the widened end portion extends over one or more of the second electric contact and the third electric contact. This may be the case if in the manufacturing process the first electric contact is provided subsequent to providing the second electric contact and the third electric contact.

In an embodiment the improved tandem solar cell has an interface that comprises a charge carrier selective contact layer of the first photovoltaic component and a charge carrier selective contact layer of the second photovoltaic component, which charge carrier selective contact layers have a same conductivity type. Particularly in the case of perovskite solar (sub)cells, charge carrier selective contact layers are often named "charge carrier transport layer", for example electron transport layer or hole transport layer. In the following we will use the generic term 'charge carrier selective contact layer', or short 'n-type contact layer' or 'p-type contact layer', and also in case of perovskite-based photovoltaic component the term 'charge transport layer' interchangeably. As will be apparent from the detailed description, this embodiment, also denoted as 'reverse type', allows for relatively simple electrical interconnections in a tandem solar cell arrangement comprising a plurality of such tandem solar cells. In one example of the reverse type, the charge carrier selective contact layer of the first photovoltaic component is an n-type contact layer of a Silicon based photovoltaic component and the charge carrier selective contact layer of the second photovoltaic component is an electron transport layer of a perovskite based photovoltaic component. In another example thereof the charge carrier selective contact layer of the first photovoltaic component is a p-type contact layer of a Silicon based photovoltaic component and the charge carrier selective contact layer of the second photovoltaic component is a hole transport layer of a perovskite based photovoltaic component. In some examples of this embodiment the interface further comprises a transparent conductive layer, for example a transparent conductive oxide (TCO) layer, sandwiched between said charge carrier selective contact layers. Such a TCO layer is a layer with a high transparency (e.g. more than 90%, more preferably more than 95%) for visible and near-infrared light as well as a sufficient electric conductivity (the conductivity is related to doping level which needs to be sufficient for good electrical contact to both charge carrier selective contact layers, and the conductivity needs to be sufficient for transport of carriers between the two photovoltaic components without excessive resistive loss, e.g. having a specific conductivity of more than 10 Scm²). The TCO layer is a layer of for example indium tin oxide (ITO), indium zinc oxide (IZO), zinc tin oxide (ZTO), aluminum zinc oxide (AZO), indium gallium zinc oxide (IGZO). The thickness can range between about 1 nm and about 50 nm. Also an ultra-thin (e.g. about 1nm thickness) metal layer may be used.

In an alternative embodiment the improved tandem solar cell has an interface that comprises a charge carrier selective contact layer of the first photovoltaic component and a charge carrier selective contact layer of the second photovoltaic component, which charge carrier selective contact layers are of a mutually different conductivity type. As will be apparent from the detailed description this embodiment, also denoted as 'serial type', is less favorable due to the more complicated electrical interconnections required to integrate tandem solar cells of this type in a tandem solar cell arrangement. In one example of the serial type, the charge carrier selective contact layer of the first photovoltaic component is an n-type contact layer of a Silicon based photovoltaic component and the charge carrier selective contact layer of the second photovoltaic component is a hole transport layer of a perovskite based photovoltaic component. In another example thereof the charge carrier selective contact layer of the first photovoltaic component is a p-type contact layer of a Silicon based photovoltaic component and the charge carrier selective contact layer of the second photovoltaic component is an electron transport layer of a perovskite based photovoltaic component. In some examples of this embodiment the interface further comprises a recombination layer sandwiched between said charge carrier selective contact layers, where p-type carriers from one subcell recombine with n-type carriers from the other subcell. Materials for this layer may comprise materials as described for the transparent conductive interface layer described in the previous paragraph for the reverse type tandem solar cell.

The n-type and p-type contact layers for the silicon based photovoltaic component may be embodied for example, as silicon heterojunctions as used in different varieties of silicon heterojunction solar cells, stacks of thin oxide and doped polysilicon (so-called TOPCon or POLO contacts), doped surface layers of the silicon wafer, charge carrier selective metal oxide layers, stacks of an Al-doped silicon surface area and Al-Si alloy as known as p-type contacts in PERC technology, etc. The details of these contact layers may be optimized specifically for tandem application.

In embodiments of the improved tandem solar cell the second electric contact and the third electric contact each are provided as a grid comprising one or more busbars and fingers integral with the busbars and extending in transverse direction away therefrom. Furthermore, the one or more via connections do not intersect the busbars. In some cases, the one or more via connections may intersect the contact fingers as this has less impact on the efficiency of the panel. This impact can be further restricted in an embodiment wherein the contact fingers are connected at both ends to a busbar. In that case both sides of an intersected contact finger are still electrically connected to the respective electric contact.

In embodiments of the improved tandem solar cell the one or more via connections only intersect the charge carrier selective contact layers of the second photovoltaic component with the conductivity type opposite to that of the second photovoltaic absorber layer. For example if the second photovoltaic component comprises an n-type Si wafer as the second photovoltaic absorber layer, the via connections should only intersect the charge carrier selective contact layers that extract holes, i.e. the emitter areas. This is advantageous in that non-equilibrium carriers created in the n-type contact regions can diffuse the relatively long distance to the emitter regions without risk of recombination at the via.

The present disclosure also provides an improved tandem solar cell arrangement comprising a plurality of improved tandem solar cells. In the improved arrangement the plurality of improved tandem solar cells are arranged at subsequent positions along a first spatial direction of a plane, and the second electric contact and the third electric contact of each tandem solar cell are arranged at mutually different positions in a second spatial direction, transverse to the first spatial direction of the plane. As mentioned above, most favorable is a tandem solar cell arrangement of improved tandem solar cells of the reverse type, wherein the interface comprises a charge carrier selective contact layer of the first photovoltaic component and a charge carrier selective contact layer of the second photovoltaic component of the same conductivity type, and wherein the first photovoltaic component and second photovoltaic component of the tandem solar cell operate under a voltage ratio of approximately 2:1. This allows for an efficient interconnection of the improved tandem solar cells wherein the second electric contact of each tandem solar cell is connected to the third electric contact of the subsequent tandem solar cell and wherein the first electric contact of each solar cell is connected to the second electric contact of the subsequent solar cell.

In an embodiment of the improved tandem solar cell arrangement respective electrical connections between an electric contact of a tandem solar cell and an electric contact of a subsequent tandem solar cell are provided as a straight metal wire or flat wire (ribbon) that is soldered or adhered by an electrically conductive adhesive or any other method known in the technology of interconnection of back-contacted solar (sub)cells.

In an embodiment, the tandem solar cell comprises a p-type Si wafer, and the charge selective contact layer for p-type charge carriers comprises an Al-Si alloyed contact. A charge selective contact layer comprising an Al-Si alloy can be formed at relatively low process temperatures, which facilitates the manufacturing process and results in a better wafer quality. As p-type charge carriers are the majority charge carrier in a p-type wafer the Al-Si alloying based charge selective contact layer can have a small surface area, therewith minimizing recombination.

In an embodiment the tandem solar cell comprising the p-type Si wafer a front surface of the p-type silicon wafer facing the first main side and a rear surface of the p-type silicon wafer facing the second main side are each provided with a tunnel oxide layer and a doped polysilicon layer of n-type conductivity. On the rear surface the tunnel oxide layer and the doped polysilicon layer of n-type conductivity form a patterned layer stack provided with gaps in the patterned layer stack. The charge selective contact layer comprising the Al-Si alloy is arranged within each of the gaps, in electrical contact with the p-type Si wafer. One or more Ag contacts or transition metal contacts are arranged on the patterned doped polysilicon layer and in electrical contact with the patterned doped polysilicon layer.

In accordance with the above-mentioned object the present disclosure further provides an improved method of manufacturing a tandem solar cell. The improved method comprises:
Providing a silicon wafer of a first conductivity type, i.e. an n-type silicon wafer or a p-type silicon wafer.

Providing charge carrier selective contact layers of the first conductivity type and charge carrier selective contact layers of a second conductivity type opposite to the first conductivity type in respective mutually distinct regions on a main surface of the silicon wafer. The silicon wafer and the charge carrier selective contact layers of the first conductivity type and charge carrier selective contact layers of the second conductivity type form the second photovoltaic component.

Depositing on a further main surface of the silicon wafer, opposite said main surface subsequently:
a first front charge carrier selective contact layer;
a perovskite photovoltaic absorber layer;
a second front charge carrier selective contact layer, which first front charge carrier selective contact layer and second front charge carrier selective contact layers are of mutually opposite conductivity types;
Drilling at least one through-hole through the stack formed in the preceding steps;
Providing a surface of the at least one through hole with an electrically insulating wall;
Depositing first, second and third electrically conductive grids that are respectively electrically connected to the second front charge carrier selective contact layer, the charge carrier selective contact layers of the first conductivity type and the charge carrier selective contact layers of the second conductivity type, wherein depositing the first electrically conductive grid comprises forming an electrical connection from the first electrically conductive grid via the at least one through hole to form a first electric contact at an opening of the at least one through hole opposite the first electrically conductive grid, the second and the third electrically conductive grid forming the second and the third contact respectively.

Therewith an improved tandem PV cell is provided with a Si substrate and a perovskite top cell and three terminals at its rear side.

An embodiment of the improved method comprises simultaneously providing a tunnel oxide layer on the main surface and on the further main surface of the silicon wafer. This step of simultaneously providing precedes the step of providing charge carrier selective contact layers. Furthermore, the step of providing charge carrier selective contact layers comprises simultaneously providing a polysilicon layer on the tunnel oxide layer on the main surface and on the tunnel oxide layer on the further main surface. In comparison to a diffused homojunction front side, the front oxide/polysilicon stack in this embodiment improves the Si cell performance while allowing a conductive contact to the perovskite top cell. If the polysilicon on the front side is p-type doped, it will constitute a front passivating base contact layer. If the polysilicon on the front side is n-type doped, it will constitute a front floating emitter.

In an embodiment, the improved method comprises a hydrogenation treatment of the stack formed by the tunnel oxide layer and the polysilicon layer on the further main surface. This optional hydrogenation treatment of the front side results in an improved cell performance. This front side hydrogenation can, for example, be executed by front-side deposition of a sacrificial hydrogencontaining dielectric layer and optional anneal after the stack comprising the tunnel oxide layer and the polysilicon layer has been formed on the further main surface.

Alternatively the stack formed by the tunnel oxide layer and the polysilicon layer on the further main surface may be hydrogenated by deposition thereon of a functional layer for the first photovoltaic component. For example, it is known that AZO (aluminium-doped zinc oxide) or NiO layers deposited by ALD are rich in hydrogen which can be applied to enhance the passivation by an oxide/polysilicon stack.

### BRIEF DESCRIPTION OF THE DRAWINGS

These and other aspects are described in more detail with reference to the drawing. Therein:
FIG. 1A and 1B schematically show a portion of an embodiment of an improved tandem solar cell. Therein FIG. 1A shows a cross-section and FIG. 1B shows a bottom view according to IB in FIG. 1A.
FIG. 2 shows a bottom view of a larger section of a tandem solar cell 1 as shown in FIG. 1A, 1B.
FIG. 3A and 3B schematically show a portion of another embodiment of an improved tandem solar cell. Therein FIG. 3A shows a cross-section and FIG. 3B shows a bottom view according to IIIB in FIG. 1A.
FIG. 4A, 4B show an alternative embodiment. Therein FIG. 4B is a bottom view according to IVB in FIG. 4A.
FIG. 5A, 5B show a further alternative embodiment. Therein FIG. 5B is a bottom view according to VB in FIG. 5A.
FIG. 6 schematically shows a solar cell arrangement comprising a plurality of tandem solar cells. FIG. 6A, 6B show details of alternative embodiments.
For comparison, FIG. 7 shows a solar cell arrangement comprising a plurality of tandem solar cells of a different type.
FIG. 8AA, 8AB, .... 8G, schematically show a method of manufacturing an improved tandem solar cell.

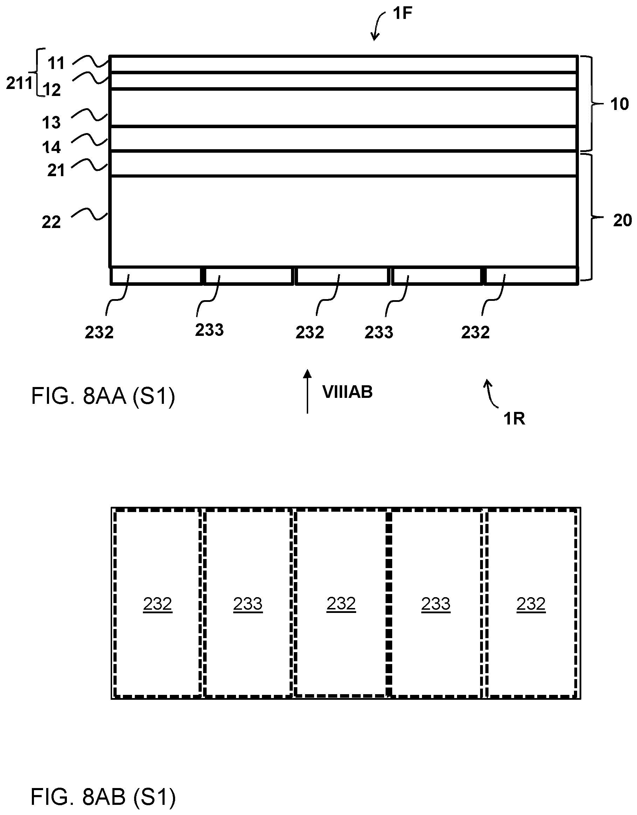

FIG. 8AA and FIG. 8AB depict a first step S1 of the method, wherein FIG. 8AB is a bottom view according to VIIIAB in FIG. 8AA.

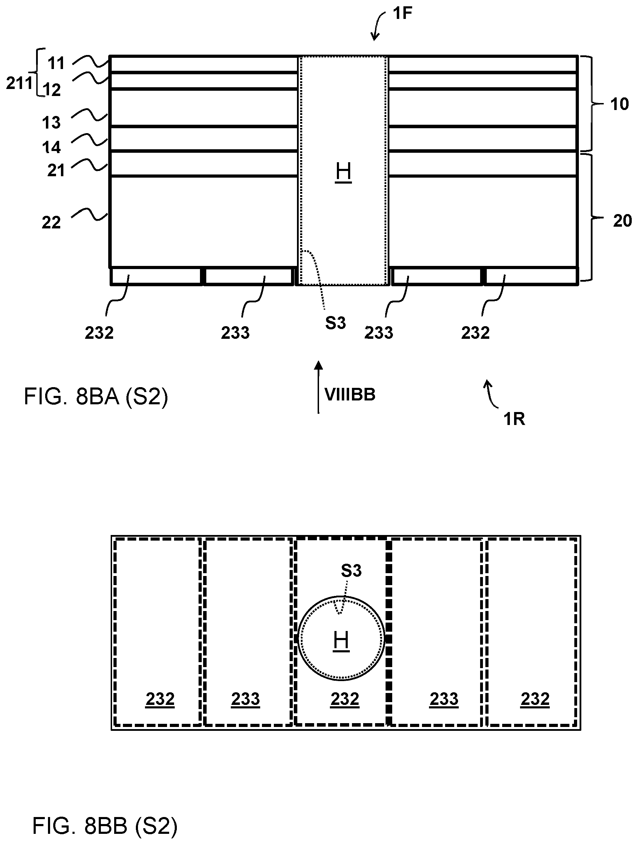

FIG. 8BA and FIG. 8BB depict a second step S2 of the method, wherein FIG. 8BB is a bottom view according to VIIIBB in FIG. 8BA.

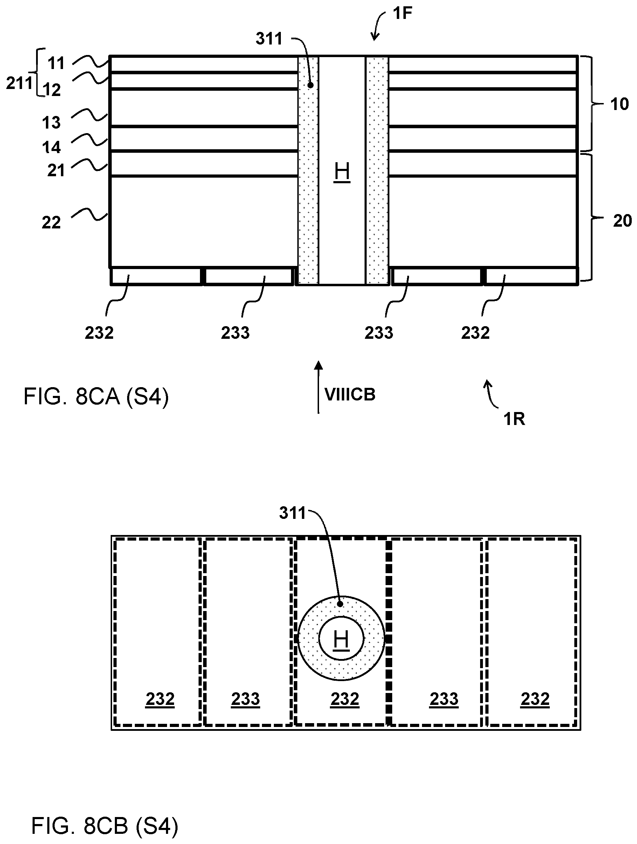

FIG. 8CA and FIG. 8CB depict a fourth step S4 of the method, wherein FIG. 8CB is a bottom view according to VIIICB in FIG. 8CA.

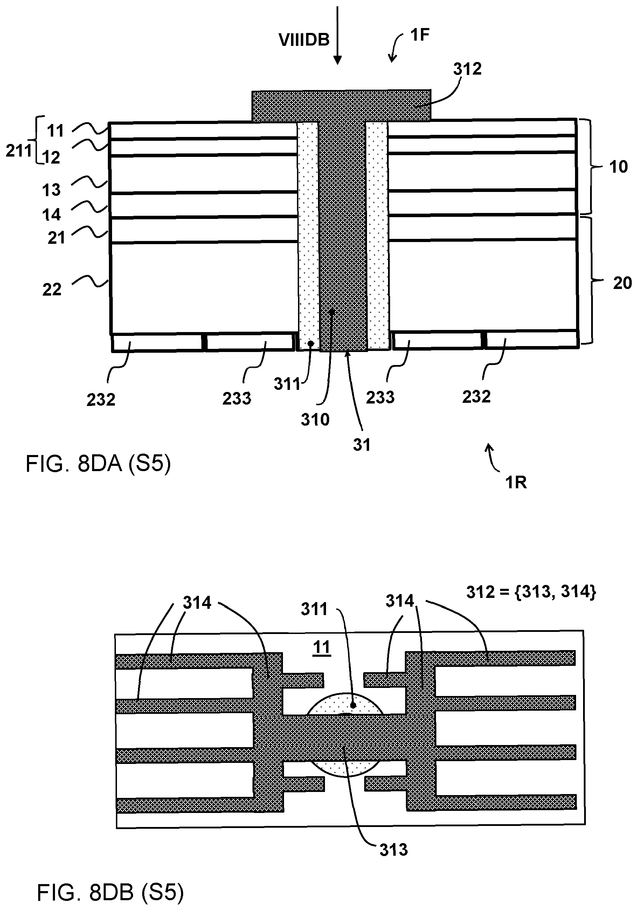

FIG. 8DA and FIG. 8DB depict a fifth step S5 of the method, wherein FIG. 8DB is a top view according to VIIIDB in FIG. 8DA.

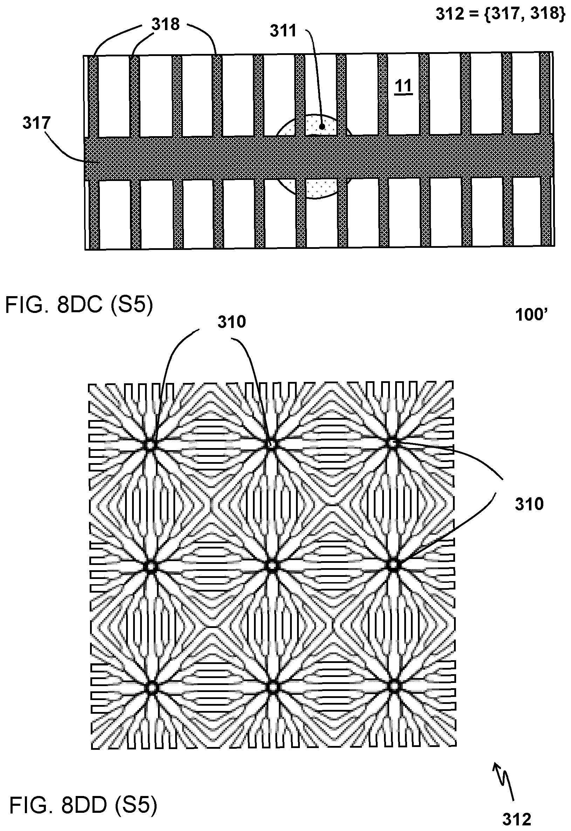

FIG. 8DC and FIG. 8DD show variations of this fifth step.

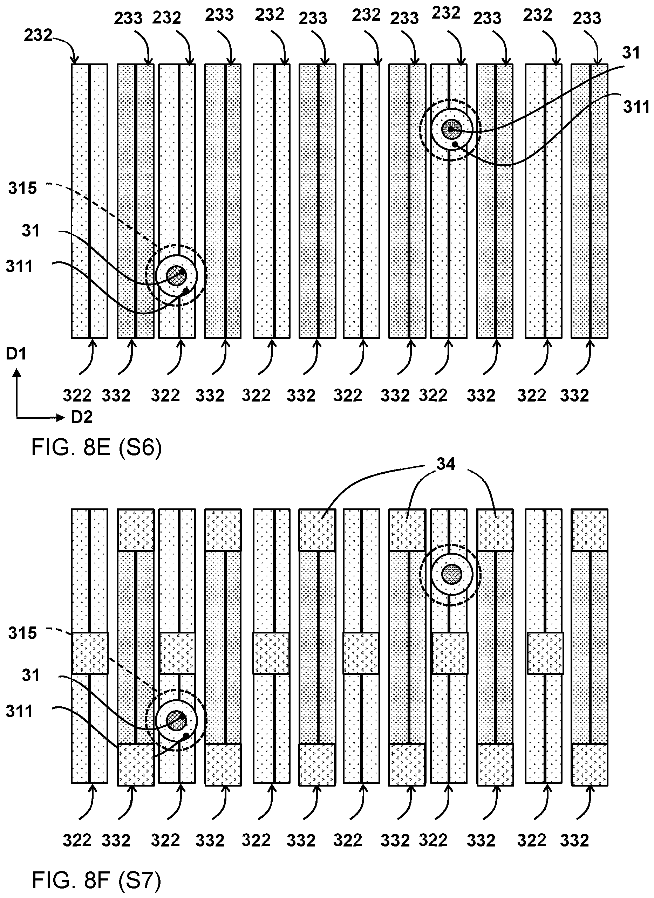

FIG. 8E shows a sixth step.
FIG. 8F shows a seventh step.

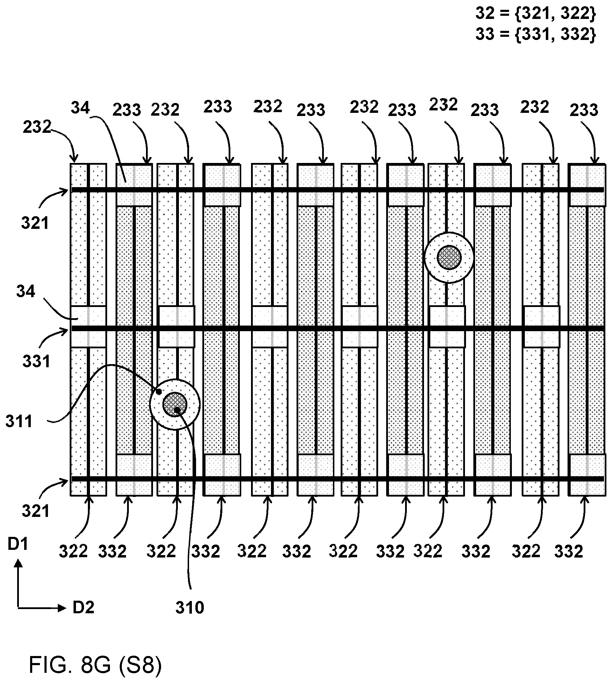

FIG. 8G shows an eighth step.

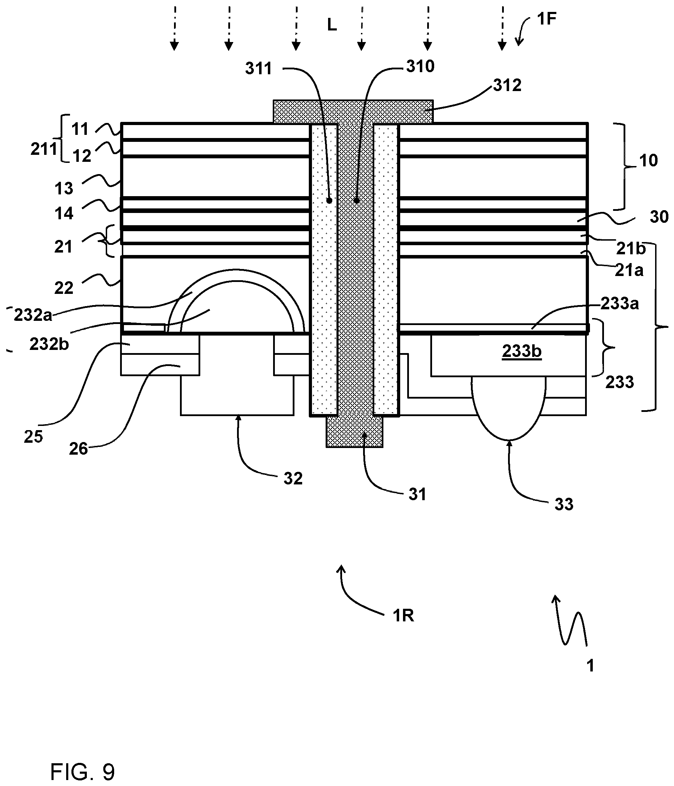

FIG. 9 shows a still further embodiment of an improved tandem solar cell.

### DETAILED DESCRIPTION OF EMBODIMENTS

Like reference symbols in the various drawings indicate like elements unless otherwise indicated.

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

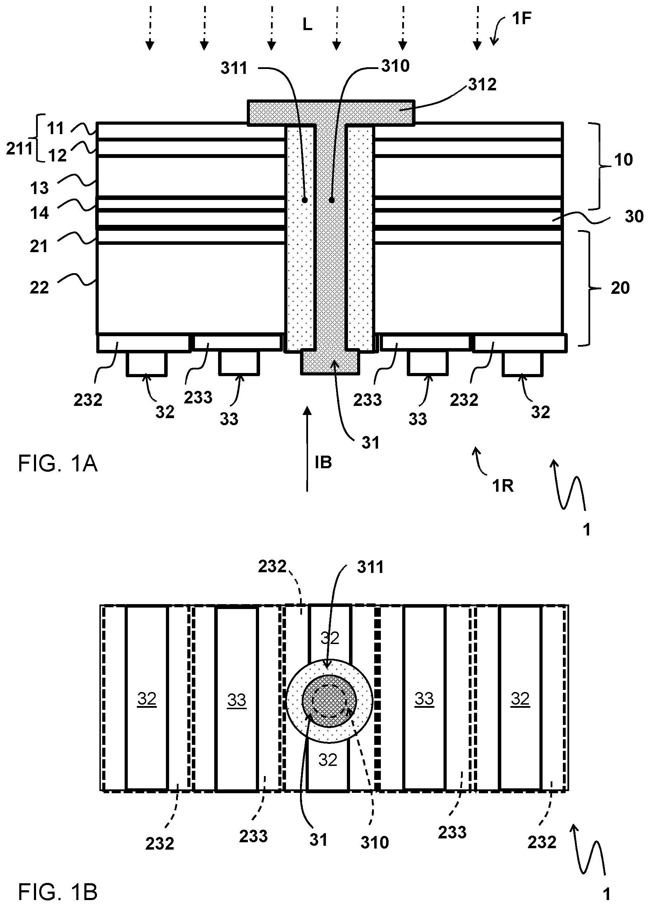

FIG. 1A and 1B schematically show a portion of an embodiment of an improved tandem solar cell 1. Therein FIG. 1A shows a cross-section and FIG. 1B shows a bottom view according to IB in FIG. 1A. As best visible in FIG. 1A, the improved tandem solar cell 1 comprises a stack of a first photovoltaic component 10 that defines a first main side 1F and a second photovoltaic component 20 that defines a second main side 1R.

The tandem solar cell 1 is configured to perform a photovoltaic conversion of light L and to provide electrical energy resulting from the photovoltaic conversion at electric contacts 31, 32, 33 at the second main side 1R. The electric contacts comprise at least a first electric contact 31 that is electrically connected by a via connection 310 through the stack to a charge carrier selective contact layer 211 of the first photovoltaic component 10 at the first main side 1F, and a second electric contact 32 and a third electric contact 33 that are connected to respective charge carrier selective contact layers 232, 233 of the second photovoltaic component 20 at the second main side 1R.

In the drawing the tandem solar cell 1 receives the light L to be converted at its first main side 1F. This is the preferred orientation of the tandem solar cell 1 as all electric contacts are provided at the second main side 1R. Nevertheless, the tandem solar cell may also be configured, although to a lesser extent, to convert light received from the second main side 1R.

In the embodiment shown, the tandem solar cell 1 is provided with a first electric contact grid 312 that electrically connects the via connection 310 with the charge carrier selective contact layer 211 of the first photovoltaic component 10. The via connection 310 is surrounded by a hull 311 of an electrically insulating material and the first electric contact 31 is provided at an end surface of the hull at the second main side 1R.

In the embodiment of the tandem solar cell 1 in FIG. 1A, 1B, the first photovoltaic component 10 comprises a perovskite based photovoltaic absorber layer 13. The charge carrier selective contact layer 211 comprises a pair of sublayers, of which a first sublayer is a transparent conductive oxide layer 11 that has a surface that electrically contacts the grid 312 and an electron transport layer 12 that is arranged between the transparent conductive oxide layer 11 and the perovskite based photovoltaic absorber layer 13. At a side opposite the electron transport layer 12, the perovskite based photovoltaic absorber layer 13 is provided with a hole transport layer 14.

The second photovoltaic component 20 of the tandem solar cell 1 shown in FIG. 1A, 1B comprises a silicon based photovoltaic absorber layer 22. The second photovoltaic component 20 further comprises an n-type contact (i.e., short for n-type charge carrier selective contact) layer 21 at a side facing the first photovoltaic component 10 and charge carrier selective contact layers 232, 233. The charge carrier contact layers include emitter sections 232 and base contact sections 233 that alternate each other. With an n-type silicon wafer the emitter sections 232 are hole selective and the base contact sections 233 are electron selective. With a p-type silicon wafer the emitter sections 232 are electron selective and the base contact sections 233 are hole selective

Second electric contacts 32, and third electric contacts 33 are provided on the charge carrier selective contact layers 232, 233 respectively.

As best shown in FIG. 1A, the tandem solar cell 1 has an interface that comprises the charge carrier selective contact layer 14 of the first photovoltaic component 10 and the charge carrier selective contact layer 21 of the second photovoltaic component 20. In this example the charge carrier selective contact layers 14, 21 are of a mutually different conductivity type. For easy reference the tandem solar cell having such an interface will also be denoted as 'serial type'. In the example shown, the interface between the first photovoltaic component 10 and the second photovoltaic component 20 further comprises a recombination layer 30, for example a layer of a transparent conductive layer, such as a transparent conductive oxide, such as ITO, sandwiched between the charge carrier selective contact layers 14, 21.

As is best visible in FIG. 1B, the via connection 310 only intersects the charge carrier selective contact layer 232 of the second photovoltaic component 20 with the conductivity type opposite to that of the second photovoltaic absorber layer 22. In this example the second photovoltaic absorber layer 22 is an n-type Si-wafer and the charge carrier selective contact layer 232 that is intersected by the via connection 310 is a p-type charge carrier selective contact emitter layer.

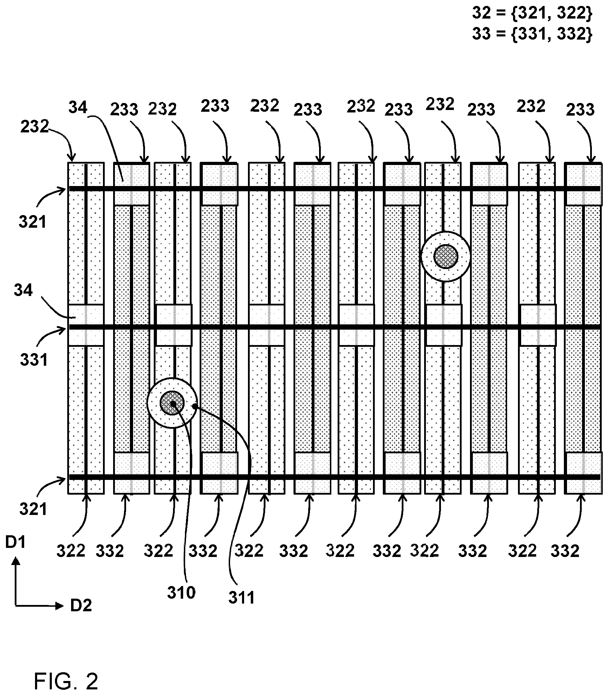

FIG. 2 shows a bottom view of a larger section of a tandem solar cell 1 as shown in FIG. 1A, 1B. As shown in this example, the second electric contact 32 and the third electric contact 33 are each provided as a grid 32, 33 comprising a busbar 321, 331 and fingers 322, 332 integral with the busbar and extending in transverse direction away therefrom. As also shown, the via connections 310 do not intersect the busbars 321, 331. In the embodiment shown in FIG. 2, the fingers 322 of the second electric contact 32 are each connected to at least two busbars 321 of the second electric contact 32. Therewith it is achieved that that both parts of the finger 322 that are resulting due to the intersection by the via connection 310 and the hull 311 remain electrically connected to a busbar 321. Although not strictly necessary for this reason, also the fingers 332 of the third electric contact 33 are each connected to at least two busbars 331 of the third electric contact 33. The fingers 321 of the second electric contact 32 are electrically insulated from the busbar 331 of the third electric contact 33 by electrically insulating pads 34. Likewise, the fingers 331 of the third electric contact 33 are electrically insulated from the busbar 321 of the second electric contact 32 by electrically insulating pads 34.

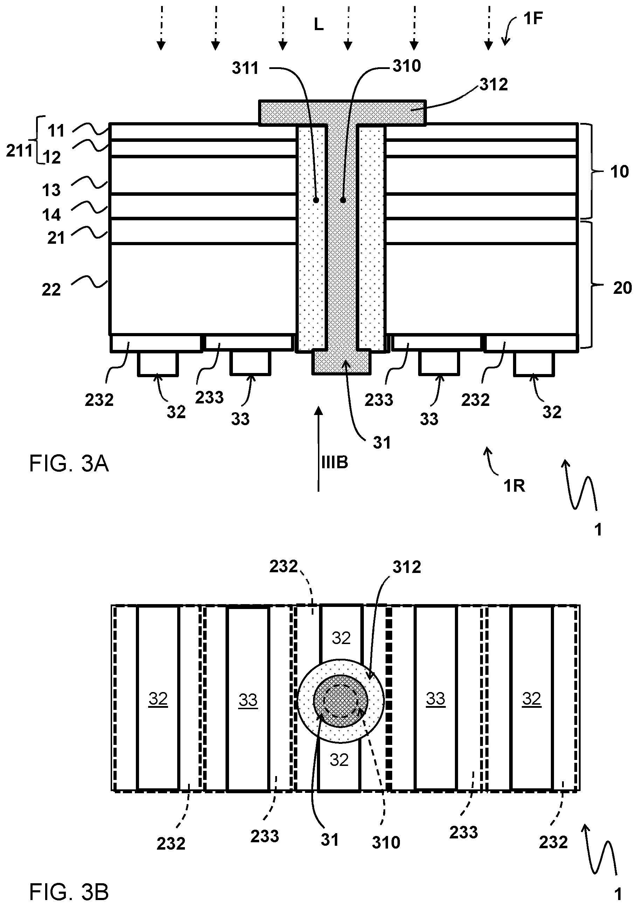

FIG. 3A and 3B schematically show a portion of another embodiment of an improved tandem solar cell 1. Therein FIG. 3A shows a cross-section and FIG. 3B shows a bottom view according to IIIB in FIG. 1A.

The tandem solar cell 1 of FIG. 3A, 3B corresponds to the example shown in FIG. 1A, 1B in that the first photovoltaic component 10 comprises a perovskite based photovoltaic absorber layer 13 and in that the second photovoltaic component 20 of the tandem solar cell 1 comprises a silicon based photovoltaic absorber layer 22. Likewise the charge carrier selective contact layer 211 comprises a pair of sublayers, of which a first sublayer is a transparent conductive oxide layer 11 that has a surface that electrically contacts the grid 312 and a charge carrier selective contact layer 12 that is arranged between the transparent conductive oxide layer 11 and the perovskite based photovoltaic absorber layer 13. Unlike the embodiment of FIG. 1A, 1B however the charge carrier selective contact layer 12 is a hole transport layer.

At a side opposite the hole transport layer 12, the perovskite based photovoltaic absorber layer 13 is provided with an electron transport layer 14.

The second photovoltaic component 20 is the same as the one in the embodiment of FIG. 1A, 1B.

As in this case the charge carrier selective contact layer 14 of the first photovoltaic component 10 that faces the second photovoltaic component 20 is an electron transport layer the embodiment of FIG. 3A, 3B differs from the embodiment in FIG. 1A, 1B in that the tandem solar cel has an interface that comprises a pair of charge carrier selective contact layers 14, 21 of the same conductivity type. For convenience this configuration of a first photovoltaic component 10 and a second photovoltaic component 20 is also denoted herein as 'reverse type'.

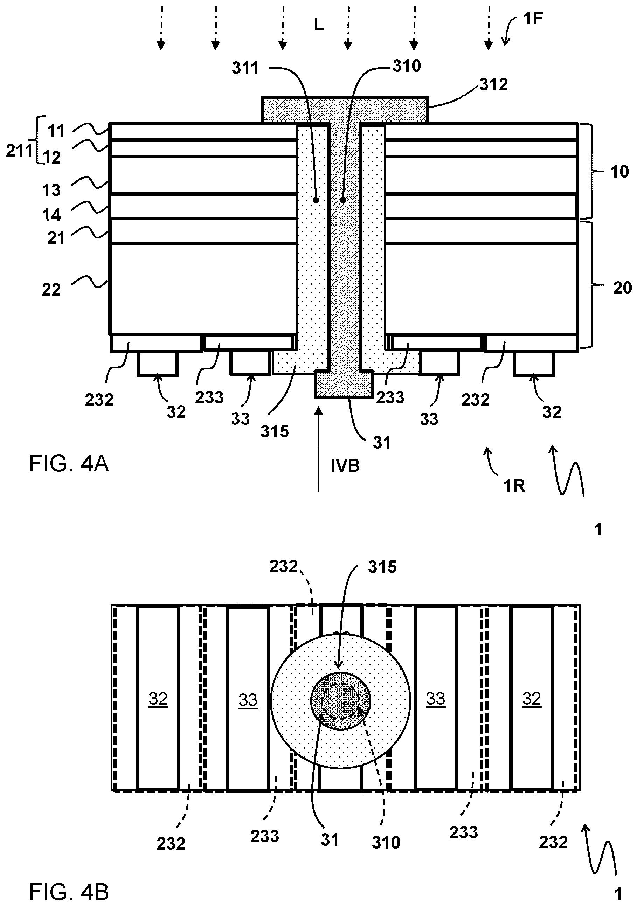

FIG. 4A, 4B shows an alternative embodiment that differs from the embodiment of FIG. 3A, 3B, in that the hull 311 has a widened end portion 315 at the second main side 1R. Therein FIG. 4B is a bottom view according to IVB in FIG. 4A. The widened end portion 315 is shaped as a disk having a diameter greater than that of the remainder of the hull, inside the stack. As shown in FIG. 4A, 4B, the widened end portion 315 extends over one or more charge carrier selective contact layers 232, 233.

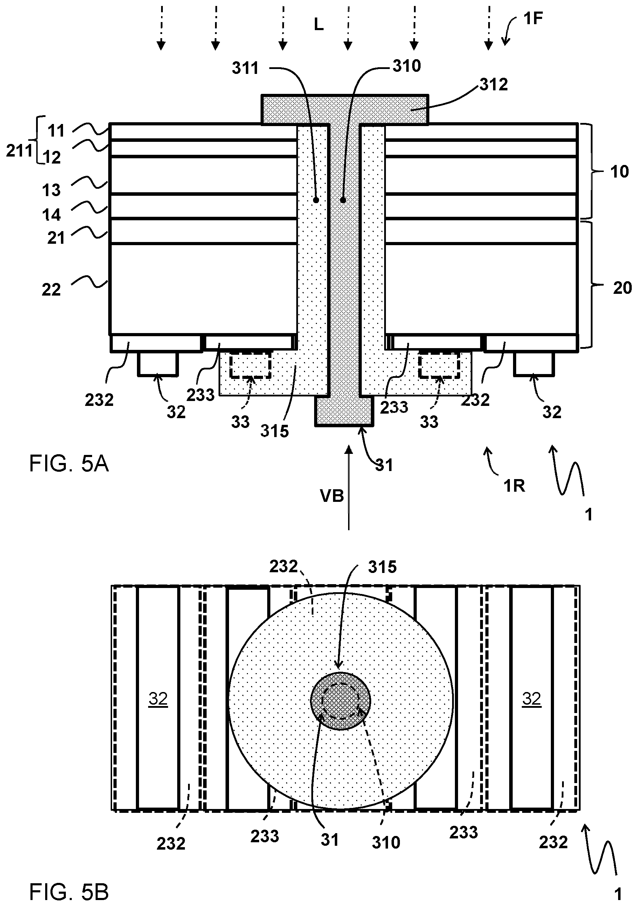

FIG. 5A, 5B show a further alternative embodiment that differs from the embodiment of FIG. 4A, 4B, in that the widened end portion 315 also extends over one or more of the second electric contact and the third electric contact 32, 33. It is noted that FIG. 5B is a bottom view according to VB in FIG. 5A.

It is noted that when the end portions of the hull are widened, as a favorable result also the electric contacts 31 may be widened or, in general, increase in area, without causing shunt to layers 232, 232 or contacts 32, 33.

It is noted that different combinations of polarities are possible, both for series-type and reverse-type of the improved tandem solar cells. Both p-type and n-type absorber layers 22 of the bottom subcell 20 may be combined with p-type as well as n-type charge carrier selective front contacts 21. A perovskite top subcell in this improved tandem solar cell may be based on p-i-n configuration (i.e., charge carrier selective contact layer 14 is hole transport layer and charge carrier selective contact layer 12 is electron transport layer) as well as n-i-p configuration (i.e., charge carrier selective contact layer 14 is electron transport layer and charge carrier selective contact layer 12 is hole transport layer).

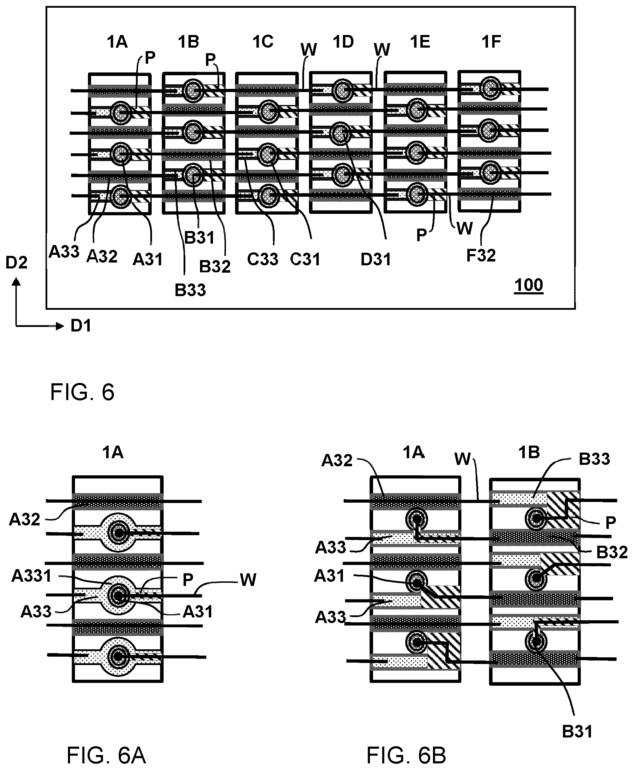

FIG. 6 schematically shows a solar cell arrangement 100 comprising a plurality of tandem solar cells 1A,...,1F that are arranged at subsequent positions along a first spatial direction D1 of a plane. Second electric contacts and third electric contacts of each tandem solar cell are arranged at mutually different positions in a second spatial direction D2, transverse to the first spatial direction of the plane. The second electric contacts and the third electric contacts respectively correspond to the busbars 321 and 331 as shown in FIG. 2. In FIG. 6 the first, the second and the third electric contacts of a tandem solar cell 1X, wherein X is A, B,...F are denoted as X31, X32, and X33 respectively. In the example shown in FIG. 6, it is presumed that the tandem solar cells 1A,...,1F are of the reverse type. As shown in FIG. 6 this renders possible a very efficient electrical interconnection by straight metal wires W. Therein the second electric contact A32 of each tandem solar cell 1A is connected to the third electric contact B33 of the subsequent tandem solar cell 1B and the first electric contact A31 of each tandem solar cell 1A is connected to the second electric contact B32 of the subsequent tandem solar cell 1B. Electrically insulating patches P are provided to avoid unintentional electric contacts. The metal wires W are electrically (and mechanically) connected at their end to the electric contacts, for example by a solder connection or by an electrically conductive adhesive.

In order to avoid that busbars of a tandem solar cell 1 are intersected they may be provided with a widened section at the location of a first electric contact. By way of example this is illustrated in FIG. 6A for a tandem solar cell 1A, wherein the third electric contact A33 has a widened section A331 that provides for a bypass around the location that is intersected for the purpose of the first electric contact A31.

FIG. 6B shows an alternative embodiment. In this embodiment the vias and the corresponding electric contacts A31, B31 are provided between the busbars A32, A33 and B32, B33 respectively.

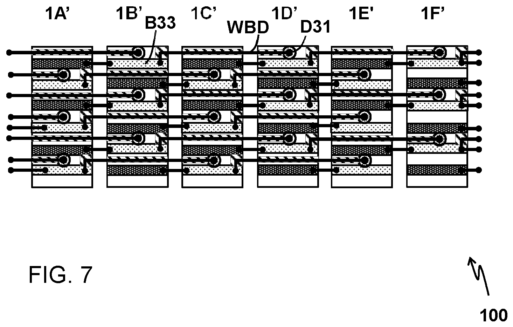

For comparison, FIG. 7 shows a solar cell arrangement 100' comprising a plurality of tandem solar cells 1A',...,1F' of the above-mentioned 'serial type'. As is immediately apparent, this type of solar cell arrangement requires a substantially more complex electrical interconnection process, as a separate electrical interconnections, e.g. WBD are necessary between a third electric contact, e.g. B33, of a tandem solar cell, e.g. 1B' and first electric contact, e.g. D31 of a tandem solar cell, e.g. 1D' subsequent to a subsequent tandem solar cell. These electrical connections, e.g. WBD, skip an intermediate tandem solar cell, e.g. 1C', and need to be electrically insulated therefrom.

FIG. 8AA, 8AB, .... 8G, schematically shows a method of manufacturing an improved tandem solar cell.

A first step S1 is depicted in FIG. 8AA and FIG. 8AB, wherein FIG. 8AB is a bottom view according to VIIIAB in FIG. 8AA. In this step a tandem solar cell configuration is provided, for example a tandem solar cell configuration comprising a c-Si IBC bottom subcell 20 and a perovskite top subcell 10, as shown in FIG. 1A, 3A, 4A, 5A. In the example shown, the tandem solar cell configuration of the reverse type, as shown in FIG. 3A, 4A and 5A is selected, as a plurality of tandem solar cells of the reverse type can be interconnected relatively easily in a tandem solar cell arrangement. It will be clear that the first step S1, in practice comprises a plurality of sub steps, wherein the Si-wafer 22 is processed, the charge carrier selective layers 232, 233 and 21 are deposited and the layers 11, 12, 13, 14 of the perovskite top subcell 10 are deposited. Taking into account that the implementation thereof is known as such, a description thereof is omitted in order not to distract attention from the more specific aspects of the present invention.

Optionally, the semifinished tandem solar cell obtained in step S1 may already be provided with contact grids 32, 33 on the rear side 1R and/or a contact grid 31 on the front side 1F. Taking into account that the implementation thereof is known as such, a description thereof is omitted in order not to distract attention from the more specific aspects of the present invention.

A next step S2 is depicted in FIG. 8BA and FIG. 8BB, wherein FIG. 8BB is a bottom view according to VIIIBB in FIG. 8BA. In this next step S2 through-holes H are drilled, for example with a laser, through the whole tandem stack. The through-holes H could be circular with a diameter of for example 300 µm, but also could be smaller (e.g. 200 µm) or larger (e.g. 400 µm). The width of the through-hole could also vary, with the through-hole being wider at one side of the wafer (typically the side from which the through-hole was drilled with the laser) than at the other side of the wafer. If paste (e.g. for isolation or metallization) is in a later step printed onto the hole from the rear side, doing laser drilling from the rear side may enable more complete filling of the hole with such paste. The through-holes H should be sufficiently wide to be able to fill them with isolation paste and metal paste. The through-holes could be penetrating the IBC bottom subcell through either the base contact areas 233 or through the emitter areas 232 or through both. Preferably however the through holes H are drilled through the charge carrier selective contact areas having a conductivity type opposite to the conductivity type of the photovoltaic absorber layer 22, i.e., the emitter areas (layer 22 is the Si-wafer). For example, if the conductivity type of the photovoltaic absorber layer is n-type, then the through holes are preferably drilled through the p-type charge carrier selective areas and if the conductivity type of the photovoltaic absorber layer is p-type, then the through holes H are preferably drilled through the n-type charge carrier selective areas. In this example, the photovoltaic absorber layer 22 is an n-type Si wafer, and accordingly the through holes H are preferably drilled through the emitter 232. Although only a single hole H is illustrated, the number is usually larger. To provide for a good electrical connection with the electrically connecting grid 312 to be formed at the front side 1F of the tandem solar cell, about 1 to 2 through holes per 1000 square mm should be drilled. For example, for a 6 inch wafer (156 x 156 mm) 6 x 6 through-holes may be provided in a grid like pattern.

In an optional step, debris resulting from the laser drilling process is removed, for example by a chemical etching process, for example by alkaline or acid solution, depending on the tolerance of the tandem solar cell half-fabricate to this etching process.

In an optional step, the through-holes are passivated, for example by deposition of a layer, for example with a chemical deposition process such as an ALD step, as shown by the dotted boundary S3. This step could optionally also result in deposition of a layer on the semifinished tandem solar cell outside the hole.

As noted in the description of step S1, some parts of the metallization grid may already be present before the steps for hole drilling, laser damage removal or through-hole passivation. However, obviously, the steps for hole drilling, laser damage removal and through-hole passivation must be performed before the formation of electrically insulating hull 311 (passivation and hull formation may also be combined), and before the formation of the electrically conductive connection 310.

FIG. 8CA and FIG. 8CB depict a fourth step S4 of the method, wherein FIG. 8CB is a bottom view according to VIIICB in FIG. 8CA.

In a step S4, an electrically insulating paste is used to provide the through holes H with an electrically insulating wall 311. This can be achieved by printing the electrically insulating paste locally on the side 1F at the positions of the through-holes H. A pressure difference between the sides 1F, 1R of the tandem stack can then be applied before the paste is dried, that forces the electrically insulating paste to flow through the through-holes H, so that the electrically insulating paste is deposited on the walls of the through-holes but an inner portion of the through holes remains open. Optionally additional pads of electrically insulating material are printed at the rear side 1R of the stack, such that a disk shaped, or more generally: larger area than the hole diameter, electrically insulating portion 315 is formed, as shown in FIG. 4A, 4B and FIG. 5A, 5B. The printed electrically insulating paste is typically dried, for example in a furnace at a temperature of 100°C.

In subsequent steps rear metal grids 32, 33 and front metal grids 312 are printed. By way of example it is presumed that first a front metal grid 312 is printed in a step S5 as shown in FIG. 8DA, 8DB, wherein FIG. 8DB is a top-view according to VIIIDB in FIG. 8DA. By way of example FIG. 8DB shows an example, wherein the front metal grid 312 is provided as a main branch 313 and smaller branches 314. In another example, shown in FIG. 8DC the front metal grid 312 comprises a busbar 317 and fingers 318. As a further alternative the front metal grid 312 may be designed to optimally combine limited shading with good current collection properties. One example thereof is shown in FIG. 8DD, as proposed in the thesis "New metallization patterns and analysis of light trapping for silicon solar cells" by A.R. Burgers.

The printed metal could be for example silver, though other metals might also be used. In an embodiment of the method the front metal grid 312 is printed such that an electrically conductive connection 310 is created from the front side metallization 312 through the through-hole towards the rear side 1R of the stack. Therewith an end portion of the electrically conductive connection 310 may also form a contact pad 31. Alternatively, the electrically conductive connection 310 (and contact pad 31) may be formed by a deposition process applied to the rear side 1R. Preferably however, a combination of processes is used, wherein a first portion of via metal is printed from the rear side 1R and subsequently a second portion of via metal is printed from the front side 1F.

Now further steps are described wherein the rear metal grids 32, 33 are deposited.

FIG. 8E shows a step S6 wherein fingers 322, 323 are printed that are aligned with the respective charge carrier selective contact layers 232, 233 respectively extending in the direction D1. Therewith it is avoided that the fingers extend over the location where the first electric contacts 31 are formed. By way of example two electric contacts 31 are shown, which in this case are end portions of electrically conductive connection 310. As schematically shown by the dashed contour, pads 315 of isolation paste may be deposited before or after printing the fingers 322, 323. Therewith solder connections with the first electric contacts 31 can be made with a larger spatial tolerance. Preferably, the electrically insulating pads 315 are deposited subsequent to depositing the rear metal grids 32, 33, to therewith obtain the result as shown in FIG. 5A, 5B. In that case the fingers 322 can extend below the electrically insulating pads in contact with the charge selective contact layers 232.

FIG. 8F shows a step S7, wherein electrically insulating pads 34 are deposited to prevent electric contacts between fingers and busbars of mutually opposite polarity.

In a subsequent step S8, shown in FIG. 8G, the busbars 321 and 331 are deposited. As shown in FIG. 8G, therewith the fingers 322 that extend over the charge carrier selective contact layers 232 are therewith electrically interconnected with the busbars 321. Likewise the fingers 332 that extend over the charge carrier selective contact layers 233 are therewith electrically interconnected with the busbars 331. Although only two busbars 321 and only one busbar 331 are shown in FIG. 8G, in practice a plurality of busbars of each polarity will be present. Therewith it is achieved that the fingers 322, 332 are electrically connected to two or more busbars 321, 331 respectively. By way of example the distance between two mutually subsequent busbars of the same polarity is in the order of 10 to 50 mm, and their width may be in the order of 0.5 mm. In some examples the busbars 321, 331 may have widened sections to facilitate soldering of interconnection wires W thereto, and narrowed sections in-between. The fingers 322, 332 may have a width in the order of 15 to 300 micron. A thickness of the fingers 322, 332 and of the busbars 321, 331 may be in the order of 10 to 50 micron.

Whereas in this example the deposition of the front metal grid precedes the deposition of the rear metal grid, it will be clear that the alternative order is possible. Particularly when some of the rear metal grid requires a very high temperature treatment (for example, so-called 'firing-through') that part of the metal grid must be created before subsequent perovskite subcell processing which does not tolerate high temperature above about 200 °C.

Other methods than screen printing may be used for deposition of part or all of the metal grid pattern, for example, electroplating, electroless plating, laser transfer printing, inkjet printing, stencil printing, dispensing, etc.

The printing of parts of the rear side metallization grid and the printing of the through-hole metallization 310 and contact pad 31 from the rear side may in some cases be combined. For example, when the silicon subcell is of the silicon heterojunction type, the rear side emitter and base contact fingers and the through-hole metallization may be deposited in one step, for example by screen printing of metallization paste, if paste properties such as viscosity, rheology, conductivity, etc. are suitable for these multiple functions. Subsequently the front metal grid and the rear side isolation pads and busbars may be deposited. Alternatively, the deposition of rear side isolation pads for the busbars may be combined with application of the through-hole isolation, and/or the application of the busbar metallization may be combined with application of the through-hole metallization.

On the other hand, when the silicon subcell is of the TOPCon type, the rear side emitter and base contact fingers may be deposited and annealed before the perovskite top subcell processing. The through-hole metallization will then be deposited separately from the rear side finger grids. Again, the deposition of rear side isolation pads for the busbars may be combined with application of the through-hole isolation, and/or the application of the busbar metallization may be combined with application of the through-hole metallization. Subsequently the front metal grid may be deposited.

In a subsequent step individual tandem solar cells 1A, ..., 1F may be integrated into solar cell arrangement 100 as shown in FIG. 6 for example. Therein the individual tandem solar cells 1A, ..., 1F are electrically interconnected. This may be achieved by electrically conductive wires W that are soldered to the second and third electric contacts 321, 331 (A32, B32, .., A33, B33 etc. in FIG. 6) formed by the busbars and to the first electric contacts 31 (A31, B31 etc. in FIG. 6). Alternatively, the individual tandem solar cells 1A, .., 1F may be mounted to a backsheet (rigid or flexible) with conductive patterns providing the electrical interconnections. Alternative to soldered connection, methods may be used such as electrically conductive adhesive, welding, ultrasonic joining, etc. In the previous examples it is presumed that the second photovoltaic component 20 is provided with an n-type Silicon based wafer 22. Alternatively, the second photovoltaic component 20 may be provided with a p-type Silicon based wafer 22.

A specific example of the application of a p-type Silicon based wafer is shown in FIG. 9. Parts therein corresponding to those in FIG. 1B have a same reference number. In the example of FIG. 9, the n-type charge carrier selective contact layer 21 comprises a tunnel oxide layer 21a and an n-type poly silicon layer 21b. Likewise, the n-type charge carrier selective contact layer 233 comprises a tunnel oxide layer 233a and an n-type poly silicon layer 233b having a metal contact (e.g. Ag or other transition metal) 33. The p-type charge carrier selective contact layer 233 comprises an Al-based p-type charge selective contact region 232a and an Al-Si alloy layer 232b having an Al contact 32. It is noted that in this case, wherein the second photovoltaic component 20 is provided with a p-type Silicon based wafer 22, the p-type charge selective contact region 232a is also denoted as BSF region 232a. The contacts 31, 32, 33 extend through a stack of a layer of aluminium oxide 25, and a layer of hydrogenated silicon nitride SiNx:H 26.

An interdigitated back contact (IBC) photovoltaic component 20 having a p-type silicon substrate 22 for use in a tandem solar cell 1 as shown in FIG. 9 may be provided with the following sequence of steps 1-6:
1. Preparing the (p-type) wafer;
2. Creating a patterned emitter;
3. hydrogenation treatment of the front-side oxide/polysilicon surface passivating stack;
4. Applying the rear-surface passivation;
5. Opening of the dielectric;
6. Applying metallization.

These steps are partly based on steps 1-6 referred to in international application WO2019059765A1 and specified in more detail in p.13 ff. Also other methods are suitable.

Three implementation examples are now described in more detail, wherein the steps of Example I result in the interdigitated back contact (IBC) photovoltaic component 20 of the tandem solar cell of FIG. 9.

### Example I front side passivated by n-type polysilicon.

In a first example the (IBC) photovoltaic component 20 having a p-type silicon substrate 22 is provided with a front side passivated by n-type polysilicon.

In step 1 the p-type wafer can be prepared as specified on top of page 15 of WO2019059765A1 (WO'765). Optionally the front side may be polished or smoothened by a single sided etch to improve the performance of the perovskite top cell.

In step 2 a patterned emitter may be applied as specified in page 15, line 5 to page 17, line 11 of WO'765. However, in the claimed tandem solar cell, it is beneficial to apply a tunnel-oxide and polysilicon on the front side of the wafer as well as on the rear side, since the front oxide/polysilicon stack improves the Si cell performance while allowing a conductive contact to the perovskite top cell. If the polysilicon on the front side is n-type doped, it will constitute a front floating emitter.

An n-type doped front-side polysilicon layer in addition to the rear-side polysilicon emitter requires a 2-sided POCl3 diffusion, which is easily accomplished by so-called single slot loading of the wafers in the diffusion furnace or LPCVD furnace, or a 2-sided implantation of n-type dopants in intrinsic polysilicon, or a 2-sided application of n-type dopant paste, or PECVD deposition of n-type doped silicon on both sides, or sputter deposition of n-type doped silicon on both sides. Possible processes for step 2 are shown in the table below:

**Table 3 Rear-side type II ( alternating bare base region, with n-type polysilicon emitter)**

| ***Textured wafer with tunnel-oxide & intrinsic polysilicon on both sides of wafer*** | ***Textured wafer with tunnel-oxide & intrinsic polysilicon on both sides of wafer*** | ***Textured wafer with tunnel-oxide & in-situ doped polysilicon on both sides of wafer*** | ***Textured wafer with tunnel-oxide & in-situ doped polysilicon on both sides of wafer*** |
|---|---|---|---|
| *Optional HF-dip* | *Optional HF-dip* | *Optional HF-dip* | *Optional HF-dip* |
| *2-sided POCl3 diffusion* | *2-sided POCl3 diffusion* | | |
| *PGR* | *PGR* | | |
| *Print etching paste pattern on rear* | *Print etch barrier pattern on rear* | *Print etching paste pattern on rear* | *Print etch barrier pattern on rear* |
| | *Wet chemical etch of rear side* | | *Wet chemical etch of rear side* |
| *Cure* | | *Cure* | |
| *Remove etching paste* | *Etch-barrier removal* | *Remove etching paste* | *Etch-barrier removal* |

**Table 4 Rear-side type III (alternating intrinsic-polysilicon with n-type polysilicon regions)**

| ***Textured wafer with tunnel-oxide & intrinsic polysilicon on both sides of wafer*** | | | |
|---|---|---|---|
| *Optional HF-dip* | | | |
| | *Print diffusion barrier pattern on rear* | *Ion implant n-type dopants on front* | *Print n-type dopant paste pattern on rear, p-type dopant paste on front* |
| | | *Ion implant n-type dopants on rear through a mask* | |
| *2-sided POCl3 diffusion* | *2-sided POCl3 diffusion* | *Anneal* | *Thermal step* |
| *PGR* | *PGR* | | |
| *Print etch barrier pattern on rear* | | | |
| *Wet chemical etch of rear side* | | | |
| *Etch-barrier removal* | | | |

Step 3: Optionally a hydrogenation treatment of the front-side oxide/polysilicon surface passivating stack is applied for better cell performance. This front side hydrogenation can be executed by front-side deposition of a sacrificial hydrogencontaining dielectric layer and optional anneal at any position in the process sequence after step 2, or it can be integrated with the first steps of the perovskite top cell process. For example, it is known that AZO (aluminium-doped zinc oxide) or NiO layers deposited by ALD are rich in hydrogen which can be applied to enhance the passivation by an oxide/polysilicon stack. A sacrificial layer for hydrogenation on the front side of the wafer can at the same time be used to protect the front-side surface from contamination during the steps 4-6.
4. Applying the rear-surface passivation;
5. Opening of the dielectric;
6. Applying metallization.

The steps 4-6 can be applied as described in WO'765, with the difference that ***no** metallization shall be applied to the front side of the cell, and that any nonconductive layers on the front side will subsequently be removed, e.g. by a chemical etch.*

### Example 2: front side passivated by p-type polysilicon

In a second example the (IBC) photovoltaic component 20 having a p-type silicon substrate 22 is provided with a front side passivated by p-type polysilicon

In step 1 the p-type wafer can be prepared as specified on top of page 15 of WO2019059765A1. Optionally the front side may be polished or smoothened by a single sided etch improve the performance of the perovskite top cell.

In step 2 a patterned emitter may be applied as specified in page 15, line 5 to page 17, line 11 of WO'765. However, in the claimed tandem solar cell, it is beneficial to apply a tunnel-oxide and polysilicon on the front side of the wafer as well as on the rear side, since the front oxide/polysilicon stack improves the Si cell performance while allowing a conductive contact to the perovskite top cell. If the polysilicon on the front side is p-type doped, it will constitute a front passivating base contact layer.

A patterned emitter on the rear side, and a p-type passivated contact layer on the front side, can be created, for example, in the following ways:

**Table 3 Rear-side type II ( alternating bare base region, with n-type polysilicon emitter)**

| ***Textured wafer with tunnel-oxide & intrinsic polysilicon on both sides of wafer*** | ***Textured wafer with tunnel-oxide & intrinsic polysilicon on both sides of wafer*** | ***Textured wafer with tunnel-oxide & in-situ doped polysilicon*** | ***Textured wafer with tunnel-oxide & in-situ doped polysilicon*** |
|---|---|---|---|
| *Optional HF-dip* | *Optional HF-dip* | *Optional HF-dip* | *Optional HF-dip* |
| *Ion implant p-type dopants on front and n-type dopants on rear* | *Print p-type dopant paste on front and n-type dopant paste on rear* | *PECVD of p-type doped silicon on front and n-type doped silicon on rear* | *Sputter deposit p-type doped silicon on front and n-type doped silicon on rear* |
| *Anneal* | | | |
| | *Thermal step* | *Anneal* | *Anneal* |
| *Either:* | | *Either:* | |
| *Print etching paste pattern on rear* | | *Print etching paste pattern on rear* | |
| *Cure* | | *Cure* | |
| *Remove etching paste* | | *Remove etching paste* | |
| *Or:* | | *Or:* | |
| *Print etch barrier on emitter regions of rear* | | *Print etch barrier on emitter regions of rear* | |
| *Wet chemical etch of rear side* | | *Wet chemical etch of rear side* | |
| *Etch-barrier removal* | | *Etch-barrier removal* | |

**Table 4 Rear-side type III (alternating intrinsic-polysilicon with n-type polysilicon regions)**

| ***Textured wafer with tunnel-oxide & intrinsic polysilicon on both sides of wafer*** | |
|---|---|
| *Optional HF-dip* | |
| *Ion implant p-type dopants on front* | *Print a p-type dopant paste on front and a patterned n-type dopant paste on rear* |
| *Ion implant n-type dopants on rear through a mask* | |
| *Anneal* | *Thermal step* |

Step 3: Optionally a hydrogenation treatment of the front-side oxide/polysilicon surface passivating stack is applied for better cell performance. This front side hydrogenation can be executed by front-side deposition of a sacrificial hydrogencontaining dielectric layer and optional anneal at any position in the process sequence after step 2, or it can be integrated with the first steps of the perovskite top cell process. For example, it is known that AZO (aluminium-doped zinc oxide) or NiO layers deposited by ALD are rich in hydrogen which can be applied to enhance the passivation by an oxide/polysilicon stack. A sacrificial layer for hydrogenation on the front side of the wafer can at the same time be used to protect the front-side surface from contamination during the steps 4-6.

Steps 4-6 can be applied as described in WO'765, with the difference that no metallization shall be applied to the front side of the cell, and that any nonconductive layers on the front side will subsequently be removed, e.g. by a chemical etch.

### Example 3: a silicon heterojunction type of front side

In a third example the (IBC) photovoltaic component 20 having a p-type silicon substrate 22 is provided with a silicon heterojunction type of front side

Finally, alternatively to a front-side stack of tunnel-oxide and doped polysilicon, the front-side wafer surface can be provided with a silicon heterojunction stack such as a stack of a layer of intrinsic a-Si:H (hydrogenated amorphous silicon) and a layer of doped a-Si:H or doped hydrogenated nanocrystalline silicon or doped hydrogenated nanocrystalline SiOx. Such a method can be based on the methods described in WO'765, with the difference that no front-side diffusion is executed, no metallization is applied to the front side of the cell, and nonconductive (dielectric) layers on the front side are omitted or will be removed before the deposition of the silicon heterojunction, e.g. by a chemical etch.

Subsequent to the process steps as described above specified in examples I, II and III, resulting in one of the exemplary (IBC) photovoltaic component 20 having a p-type silicon substrate 22 the claimed tandem solar cell can be obtained by depositing the layers of the perovskite top subcell 10 and subsequently performing the steps S2 (see FIG. 8BA, 8BB) and optionally S3 (see FIG. 8BA, 8BB), S4 (see FIG. 8CA, 8CB), S5 (see FIG. 8DA, 8DB, 8DC, 8DD), S6 (see FIG. 8E), S7 (see FIG. 8F), S8 (see FIG. 8G).

The same method as described with examples for FIG. 9 may also be applied with n-type silicon wafers to produce a second photovoltaic component 20. It is noted that process parameters may need to be specifically optimized for that substrate type, and performance characteristics may differ from the p-type IBC bottom cell.

## Claims

1. A tandem solar cell (1) comprising a stack of at least a first photovoltaic component (10) that defines a first main side (1F) and a second photovoltaic component (20) that defines a second main side (1R), the tandem solar cell (1) being configured to perform a photovoltaic conversion of light and to provide electrical energy resulting from the photovoltaic conversion of light, and to provide electrical energy resulting from the photovoltaic conversion to electric contacts (31, 32, 33) at the second main side (1R), wherein the electric contacts comprise at least a first electric contact (31) that is electrically connected by a via connection (310) through the stack to a charge carrier selective contact layer (211) of the first photovoltaic component (10) at the first main side (1F), and a second electric contact (32) and a third electric contact (33) that are connected to respective charge carrier selective contact layers (232, 233) of the second photovoltaic component (20) at the second main side (1R).

2. A tandem solar cell (1) according to claim 1, provided with a first electric contact grid (312) that electrically connects the via connection (310) with the charge carrier selective contact layer (211) of the first photovoltaic component (10).

3. The tandem solar cell (1) according to claim 1 or 2, wherein the via connection is surrounded by a hull (311) of an electrically insulating material and wherein the first electric contact (31) is provided at an end surface of the hull at the second main side (1R).

4. The tandem solar cell (1) according to claim 3, wherein the hull (311) has a widened end portion (315) at the second main side (1R).

5. The tandem solar cell (1) according to claim 4, wherein the widened end portion (315) extends over one or more charge carrier selective contact layers (232, 233).

6. The tandem solar cell (1) according to claim 4, wherein the widened end portion (315) extends over one or more of the second electric contact and the third electric contact (32, 33).

7. The tandem solar cell (1) according to one of the preceding claims, having an interface that comprises a charge carrier selective contact layer (14) of the first photovoltaic component (10) and a charge carrier selective contact layer (21) of the second photovoltaic component (20), which charge carrier selective contact layers (14, 21) have a same conductivity type.

8. The tandem solar cell (1) according to claim 7, wherein the interface further comprises a transparent conductive oxide layer sandwiched between said charge carrier selective contact layers (14, 21).

9. The tandem solar cell according to one of the preceding claims, wherein the first photovoltaic component (10) comprises one or more perovskite based photovoltaic absorber layers.

10. The tandem solar cell according to one of the preceding claims, wherein the second photovoltaic component (20) comprises a silicon based photovoltaic absorber layer (22).

11. The tandem solar cell (1) according to one or more of the preceding claims wherein the second electric contact (32) and the third electric contact (33) each are provided as a grid (32, 33) comprising a busbar (321, 331) and fingers (322, 332) integral with the busbar and extending in transverse direction away therefrom, and wherein the via connection (310) does not intersect the busbars (321, 331).

12. The tandem solar cell (1) according to one or more of the preceding claims, wherein the via connection (310) only intersects the charge carrier selective contact layers (232) of the second photovoltaic component with the conductivity type opposite to that of the second photovoltaic absorber layer (22).

13. A tandem solar cell arrangement (100) comprising a plurality of tandem solar cells (1A,...,1F) as specified in claim 7, arranged at subsequent positions along a first spatial direction (D1) of a plane, wherein the second electric contact (A32, B32, ...) and the third electric contact (A33, B33,...) of each tandem solar cell are arranged at mutually different positions in a second spatial direction (D2), transverse to the first spatial direction of the plane, wherein the second electric contact (A32) of each tandem solar cell (1A) is electrically connected to the third electric contact (B33) of the subsequent tandem solar cell (1B) and wherein the first electric contact (A31) of each tandem solar cell (1A) is electrically connected to the second electric contact (B32) of the subsequent tandem solar cell (1B).

14. A tandem solar cell arrangement (100) according to claim 13, wherein respective electrical connections between an electric contact (A31, A32) of a tandem solar cell (1A) and an electric contact (B33, B31) of a subsequent tandem solar cell (1B) are provide as a straight metal wire (W) that is soldered or adhered by an electrically conductive adhesive.

15. The tandem solar cell of claim 10, wherein the silicon wafer is a p-type Si wafer, and wherein the charge selective contact layer for p-type charge carriers is formed by an Al-Si alloyed contact.

16. The tandem solar cell of claim 15, wherein a front surface of the p-type silicon wafer facing the first main side and a rear surface of the p-type silicon wafer facing the second main side are each provided with a tunnel oxide layer and a doped polysilicon layer of n-type conductivity;
wherein the tunnel oxide layer and the doped polysilicon layer of n-type conductivity on the rear surface form a patterned layer stack provided with gaps in the patterned layer stack;
wherein the Al-Si alloyed charge selective contact layer is arranged within each of the gaps, in electrical contact with a base layer of the substrate, and one or more Ag contacts or transition metal contacts are arranged on the patterned doped polysilicon layer and in electrical contact with the patterned doped polysilicon layer.

17. A method of manufacturing the tandem solar cell of claim 10, comprising:
Providing a silicon wafer of a first conductivity type;
providing charge carrier selective contact layers of the first conductivity type and charge carrier selective contact layers of a second conductivity type opposite to the first conductivity type in respective mutually distinct regions on a main surface of the silicon wafer, the silicon wafer and the charge carrier selective contact layers of the first conductivity type and charge carrier selective contact layers of the second conductivity type forming the second photovoltaic component;
Depositing on a further main surface of the silicon wafer, opposite said main surface subsequently:
a first front charge carrier selective contact layer;
a perovskite photovoltaic absorber layer;
a second front charge carrier selective contact layer, which first front charge carrier selective contact layer and second front charge carrier selective contact layers are of mutually opposite conductivity types;
Drilling at least one through-hole through the stack formed in the preceding steps;
Providing a surface of the at least one through hole with an electrically insulating wall;
Depositing first, second and third electrically conductive grids that are respectively electrically connected to the second front charge carrier selective contact layer, the charge carrier selective contact layers of the first conductivity type and the charge carrier selective contact layers of the second conductivity type, wherein depositing the first electrically conductive grid comprises forming an electrical connection from the first electrically conductive grid via the at least one through hole to form a first electric contact at an opening of the at least one through hole opposite the first electrically conductive grid, the second and the third electrically conductive grid forming the second and the third contact respectively.

18. The method according to claim 17, comprising simultaneously providing a tunnel oxide layer on the main surface and on the further main surface of the silicon wafer, said step of simultaneously providing preceding the step of providing charge carrier selective contact layers and wherein the step of providing charge carrier selective contact layers comprises simultaneously providing a polysilicon layer on the tunnel oxide layer on the main surface and on the tunnel oxide layer on the further main surface.

19. The method according to claim 18, comprising a hydrogenation treatment of the stack formed by the tunnel oxide layer and the polysilicon layer on the further main surface.

20. The method according to claim 18, wherein the stack formed by the tunnel oxide layer and the polysilicon layer on the further main surface is hydrogenated by deposition thereon of a functional layer for the perovskite photovoltaic absorber layer.
